(19)

Europäisches
Patentamt
European
Patent Office
Office européen
des brevets

(11) **EP 3 425 084 A1**

(12) **EUROPEAN PATENT APPLICATION**

(43) Date of publication:
**09.01.2019 Bulletin 2019/02**

(51) Int Cl.:
***C23C 14/02*** *(2006.01)*　　　***C23C 14/16*** *(2006.01)*

(21) Application number: **17180342.2**

(22) Date of filing: **07.07.2017**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA MD**

(71) Applicant: **The Provost, Fellows, Foundation
Scholars, & the
other members of Board, of the College of Holy
and
Undiv. Trinity of Queen Elizabeth near Dublin
2 Dublin (IE)**

(72) Inventors:
 • **Boland, John
  Co. Dublin (IE)**
 • **Zhang, Xiaopu
  Dublin, 7 (IE)**

(74) Representative: **Lucey, Michael
PurdyLucey
Intellectual Property Limited
6-7 Harcourt Terrace
D02 FH73 Dublin 2 (IE)**

(54) **NANOSCALE METAL FILMS AND PROCESS FOR MAKING SAME**

(57)　　The invention provides a nano-scale metal or non-metal material comprising a polycrystalline or nano-crystalline grain structure wherein the orientation of at least one dislocation line within a grain boundary is modified to control the grain boundary structure and to control the size of a ridge or a valley on the metal material surface. The invention realises that due to rotation of the dislocation lines changes the grain boundary and surface structure and impacts properties that depend on these structures, for example electrical, mechanical and thermal. By controlling the interaction with the substrate or adding dopant atoms to the Grain boundaries makes it possible to modulate the forces that drive the rotation of the dislocation lines and hence control properties of the material surface. A process for making such a material is also described.

**Figure 5A**

**Description**

**Field**

The invention relates to nanocrystalline metals or non-metal material and a process and system for controlling the morphology and grain boundary structure of nanoscale metal films or layers.

**Background**

Metals are critical material components in a vast range of technologies and are employed because of their unique electrical, thermal and mechanical properties.

Metal materials are typically polycrystalline in nature and contain point (vacancies, interstitials) and linear defects (edge dislocations) and can be deposited by a range of physical and chemical deposition techniques. The grains that comprise these materials are frequently non-optimised in terms of their distribution of defects, in addition to the overall grain shape, orientation, and boundaries with nearby grains. Although thermal annealing can allow these materials to re-organise the process is kinetically constrained when the material is macroscopic in dimensions.

Nanoscale metal layers and wires and copper in particular is extensively employed in ICT as contacts and interconnects to CMOS devices. Presently interconnect technology is limiting the performance of CMOS as the electrical and thermal performance of the copper is reduced at these small dimensions, due to electron scattering from the copper surface and from grain boundaries within the copper itself. ICT industry deposit copper on a range of liners using empirical engineering approach in an attempt to minimise the resistivity of interconnects. There is no clear understanding of the underlying principles that determining the organisation of dislocations and subsequent role they play in determine surface roughness and electron scattering properties of these interconnect materials.

Nanocrystalline (NC) metals are widely used as electrical contacts and interconnects in ultra-large-scale integrated circuits. Technologically important properties of these materials, such as their electrical and thermal conductivity, and detrimental processes such as electromigration, are strongly influenced by the presence and density of surfaces, grain boundaries (GBs), and dislocations within them. A problem identified is that surface roughness of metal films can impact materials grown on existing NC films, such as dielectrics, and will impact the performance of tunneling devices based on these metals by interfering with the tunnel barrier width. For example, copper is one type of Nanocrystalline (NC) metal used extensively in the electronics industry. It is well established that copper films have a natural tendency to form (111) orientated grains. When employed as nanoscale interconnects in CMOS or other electronic devices anomalously high resistively, or resistivity is observed as dimensions are reduced.

It is therefore an object to provide an improved nanoscale metal layer or film and a process for making same.

**Summary**

According to the invention there is set out in the appended claims, a nano-scale metal material comprising a polycrystalline or nano-crystalline grain structure wherein the orientation of at least one dislocation line within a grain boundary is modified to control the grain boundary structure and to control the size of a ridge or a valley on the metal material surface.

The invention realises that due to rotation of the dislocation lines changes the grain boundary and surface structure and impacts properties that depend on these structures, for example electrical, mechanical and thermal. By controlling the interaction with the substrate or adding dopant atoms to the Grain boundaries makes it possible to modulate the forces that drive the rotation of the dislocation lines and hence control properties of the material surface.

In one embodiment the value of the shear modulus anisotropy property of the metal material is selected to modulate a rotation of the at least one dislocation line.

In one embodiment the dislocation line is configured to be modulated by doping at least one grain boundary.

In one embodiment the grain boundary is modified to interface with another material or substrate.

In on embodiment an in-plane tilt angle of the grain boundary is dependent on an out-of-plane rotation of at least one grain boundary.

In one embodiment the grain boundary is configured to form a particular asymmetric structure.

In one embodiment the grain structure is configured with a (112) or (110) plane structure.

In on embodiment the metal is selected from a group comprising at least one of: copper, nickel, gold or silver.

In one embodiment the other material comprises a CMOS or electronic device interface.

In a further embodiment there is provided a process for making a nano-scale metal material comprising a polycrystalline or nano-crystalline grain structure, said process comprising the step of modifying the orientation of at least one dislocation line within a grain boundary to control the grain boundary structure and to control the size of a ridge or a valley on the metal material surface.

In one embodiment there is provided a nano-scale metal material comprising a crystalline or grain structure wherein a grain boundary is modified to interface with another material or substrate.

In one embodiment the grain boundary is configured to form a particular asymmetric structure.

In one embodiment the metal is copper.

In one embodiment the other material comprises a CMOS or electronic device interface.

The invention demonstrates that a nanoscale copper (111) film is forced to undergo a buckling or tilting deformation at the front and back interfaces in the region of the boundaries between grains. Moreover, the dislocation lines that comprise the grain boundary are forced to adopt a particular asymmetric structure. Together by controlling or preventing one or both of these effects improves the electrical, thermal and mechanical properties of the nano-scale material or film.

The observed behaviour is due to anisotropy in the energy of the dislocation line that cause it to prefer a particular low energy direction, which forces the adjoining grains to rotate or tilt to accommodate the preferred low energy dislocation line direction.

In case of Cu this anisotropy is reflected in the anisotropy of the SF ribbon energy and its preference to lie on {111} planes.

More generally however the energy of dislocation lines scale as $\sim G b^2$, where G is shear modulus. Therefore, this tilting is expected whenever a material has a highly anisotropic G. Dislocation line will choose to lie along low G directions.

As a result of this realisation the inventors discovered that the buckling or tilting can be eliminated by choosing substrates with structures and chemistries that provide sufficient adhesion so as to prevent tilting or which promote the growth of (112) orientated films in the case of fcc metals which are not subjected to tilting The [112] direction already lies in the [111] plane and hence the dislocation lines already point in the lowest energy directions.

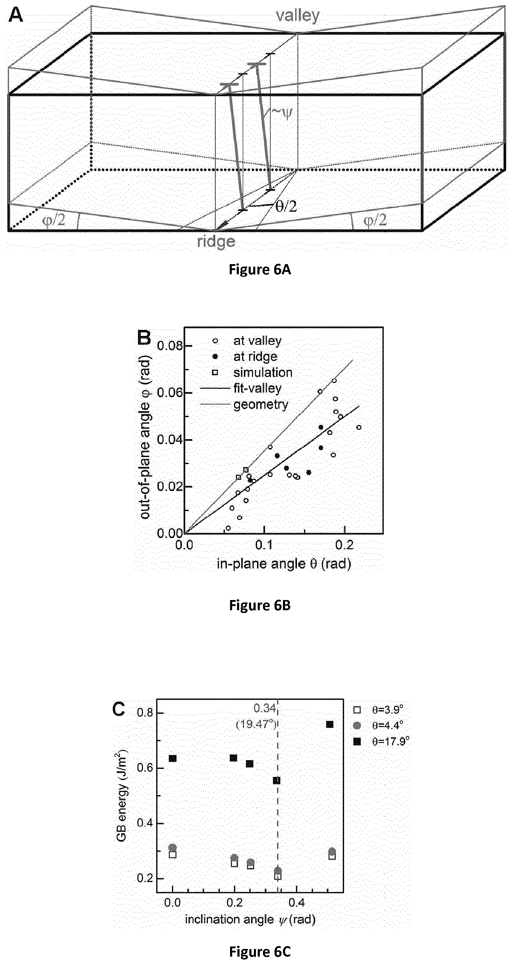

It will be appreciated that that there are two tilt angles - the usual in-plane tilt angle θ and the out-of-plane tilt angle φ (see Figure 6A) such that any wire comprised of these materials will necessarily zig-zag up-and-down and side-to-side, determining the line edge roughness of the wire. Since the electron mean-free path in Cu is about 40 nm and larger than the grain size this zig-zag wire shape will introduce additional surface scattering as carriers are accelerated along the length of the wire, in addition to requiring specific k-matching across the Brillouin zone of adjoining copper grains

The invention is particularly applicable to applications where mechanical properties of nanoscale films is important. The strength of any material is dependent on the interaction of dislocations within them. By controlling the dislocation line direction and hence the grain boundaries and the dislocation that comprise them it is possible to modify the properties of materials

It will be appreciated that the nanoscale metal material or films are not kinetically constrained and can be processed into new and unexpected films and grain structures.

In a further embodiment there is provided a process for depositing nano-scale metal material on another material or substrate, said nano-scale metal material comprising a crystalline or grain structure wherein a grain boundary is modified to interface with another material or substrate.

In another embodiment there is provided a nano-scale material comprising a polycrystalline or nano-crystalline grain structure wherein the orientation of at least one dislocation line within a grain boundary is modified to control the grain boundary structure and to control the size of a ridge or a valley on the material surface.

It will be appreciated that while the invention can be used to control the surface smoothness of any number of materials. For example the invention can be applied to any single grain deep material such as metals, insulators, semiconductors or ceramics.

**Brief Description of the Drawings**

The invention will be more clearly understood from the following description of an embodiment thereof, given by way of example only, with reference to the accompanying drawings, in which:-

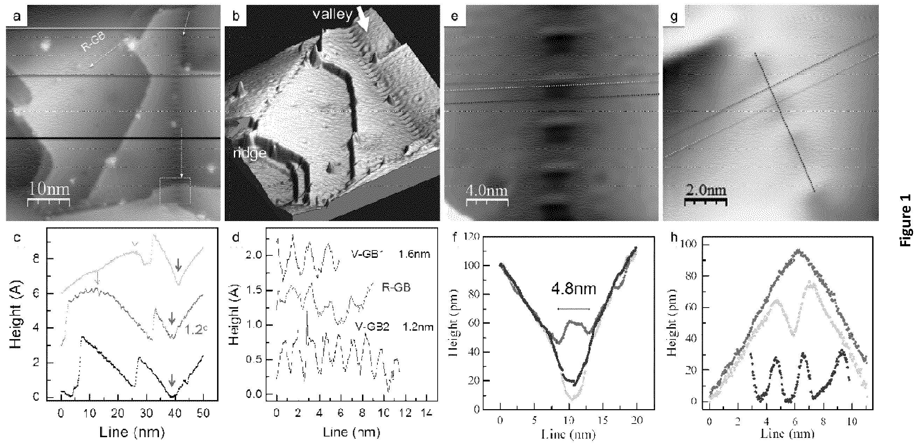

Figure 1 (a) STM image of polycrystalline copper film with (111) surface orientation with two senses of buckling, ridge and valley. (b) Perspective view of topography in (a) shows ridge grain boundary (green arrow) and valley grain boundary (white arrow) amid adjoining grains. (c) Profile of three horizontal solid lines in (a). The misorientation angle between two grains in the valley grain boundary is 2.4°. (d) Profile of three dot line with arrow in (a) along the grain boundaries at ridge and valley. The blue line goes along the grain boundary at ridge and two black lines go along the grain boundary at valley. (e) Close-up view of one grain boundary at valley. (f) Profiles of three line across the grain boundary at valley reveal the extent of surface buckling;

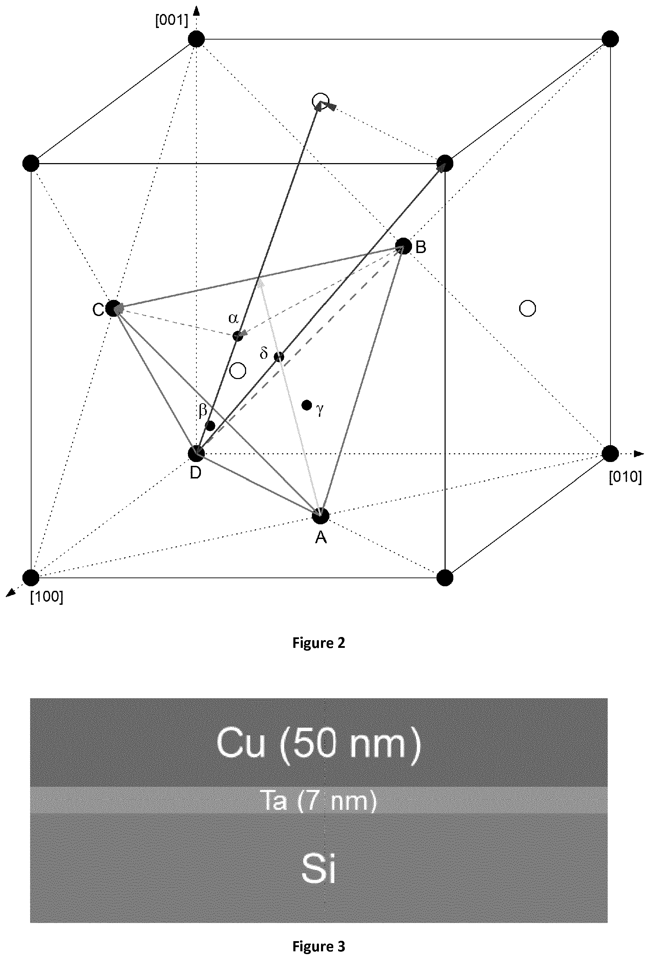

Figure 2 illustrates a Thompson tetrahedral and the notation in the crystal reference coordination;

Figure 3 illustrates a NC Cu film layer on top of a tantalum layer that had been coated on a silicon layer or wafer;

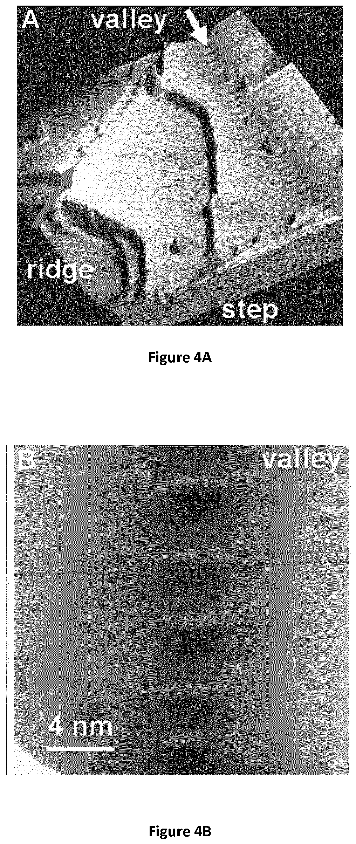

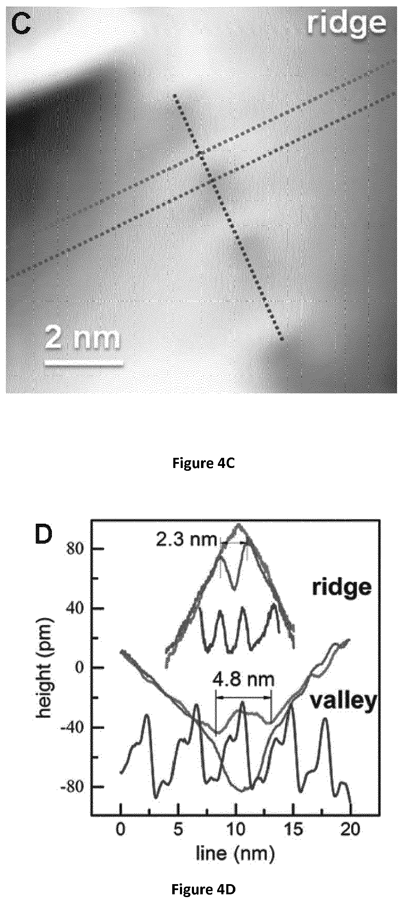

Figure 4 illustrates GBs at ridges and valleys in (111) films of Cu. (A) Perspective view of the STM topography of NC Cu copper film (Tunneling parameters: I=20pA, U=0.2V). GBs at ridge and valley location are highlighted by arrows. (B) Close-up view of one GB at valley location. (C) Close-up view of one GB at ridge location. (D) Profile of valley and ridge line cross-sections recorded in (B) and (C), respectively.

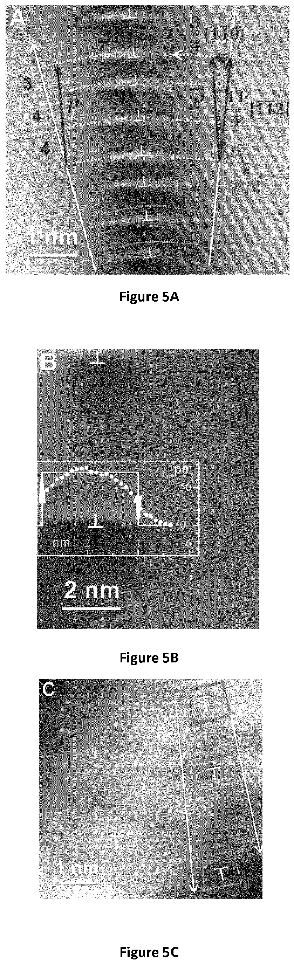

Figure 5 (A) illustrates atomic resolution STM image of a valley GB segment with ~3° out-of-plane angle. The green path shows a Burgers circuit. White dotted lines are along [$1\bar{1}0$] and solid lines along [$\bar{1}12$]. The repeat sequence 3, 4, 4 is shown along [$\bar{1}12$]. The components of $\bar{p}$ are shown in unit of $a$. The measured boundary misorientation angle $6$ between the grains is 16.2°. (B) Atomic resolution STM image of a second valley GB area with a smaller out-of-plane angle. The image contains two dissociated edge dislocations across the GB. Inset in (B) is the actual step profile (dotted lines) of the dissociated edge dislocation, including the equal and opposite Shockley partials (arrows). (C) Atomic resolution image of one segment of GB at a ridge location.

Figure 6 illustrates a relation between in-plane $\theta$ and out-of-plane $\varphi$ rotations and calculated GB energy. Schematic of LAGB induced film tilting at in-plane angle $\theta$ and out-of-plane angle $\varphi$ that shows the inclination angle $\psi$ between the dislocation line and the [111] surface normal. (B) Experimentally measured in-plane $\theta$ and out-of-plane $\varphi$ rotations. (C) Calculated GB energy dependence on the inclination angle $\psi$ for a range of in-plane angles $\theta$. Note that each exhibits a minimum at $\psi$=19.47°.

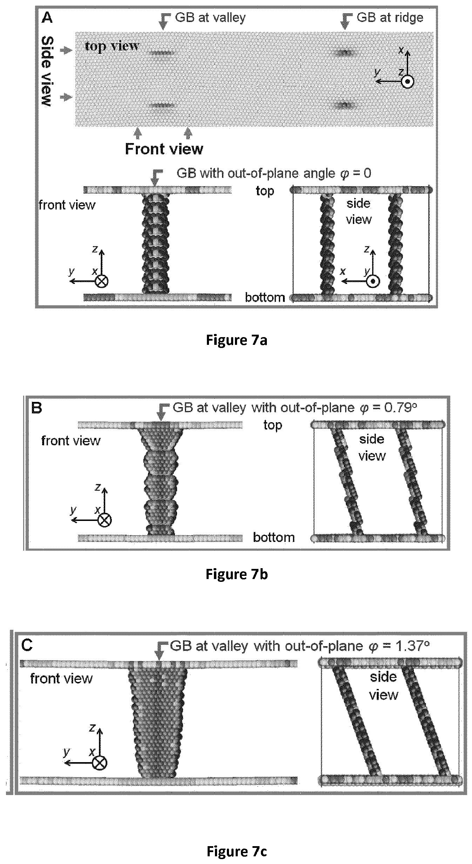

Figure 7 illustrates a molecular statics calculation of LAGBs with $\theta$ = 3.89°. Out-of-plane rotation angle are $\varphi$ = 0 (A), $\varphi$ = 0.79° (B) and $\varphi$= 1.37° (C). Atoms are colored by central symmetry and hence only defect atoms are visible. Front views show that the density reduction of jogs and increasing separation of the partials as $\psi$ approaches $\varphi$ = 19.4°. Side views shows the inclination of two SFs of one GB. Top view demonstrates the breakdown of inversion symmetry.

## Detailed Description of the Drawings

Figure 1 shows the various structures shown on an annealed copper film. The surface is comprised of grain boundaries located at valley and ridge structures. During an annealing process, the deposited film will undergo recovery in which isolated dislocations become mobile and align into low angle grain boundaries. In comparison with a perfect film without low angle grain boundaries, a film with low angle grain boundaries is comprised of two half crystals with opposite rotations around the surface normal in the so called median lattice reference coordination, as illustrated in Figure 2. The dislocation line and the tilt axis share the same direction for the low angle grain boundary.

For films with surface normal [111], the dislocation line does not lie in {111} plane and so the dislocation is not in its lowest energy state. To lower the dislocation energy, the film will buckle to rotate the dislocation line into <112> direction in a {111} plane. It was observed that there is an out-of-plane rotation in addition to the in-plane rotation associated with the grain boundary.

Figure 1 (a) show the area with two types of buckling. A 3D perspective view of Figure 1(a) is shown in Figure 1(b), where the white arrow points to a valley buckling and the green arrow points to a ridge buckling. Detailed structures of the valley buckling are shown in Figure 1(e) and (f), those of the ridge buckling are shown in Figure 1(g) and (h). The presence of grain boundaries and their emergence at the film surface create valleys composed of dissociated edge dislocations and ridges where partial dislocations have recombined.

Take the crystal reference coordination in Figure 2 as the median plane reference coordination. The in-plane rotation of the grain boundary necessary misaligns the [112] directions either side of the boundary. The out-of-plane rotation will recover this misalignment to some extent. For certain combinations of in-plane angle and the out-of-plane angle, the two sequent rotations is equivalent to one rotation with axis [112] lying in the DBC close-packing plane shown in Figure 2. It means that the out-of-plane rotation rotates the tilt axis from [111] to [112]. Note that this kind of grain rotation is not possible in macroscopic films were the large numbers of grain frustrate rotation.

If a film has a surface orientation of <112> or <110>, the tilt axis of the low angle grain boundaries is <112> or <110>. The dislocation line is along the <112> or <110> direction. Those directions are all in the {111} plane. The energy of dislocation are at their lowest energy states. There is no corresponding torque to rotate the dislocation line. Consequently there will be no surface buckling.

The invention also provides a deposition process that enables controlled growth of <112> or <110> films. In another embodiment this will involve the use of substrates whose lowest energy surfaces are a good lattice match to the {112} or {110} planes of the grown film.

The dislocation lines that comprise the GBs within a nanocrystalline film are typically not normal to the film surface, as has always been supposed. Rather dislocation lines in any material have a preferred direction and by allowing the dislocation line to rotate into this preferred direction causes a concomitant rotation of the adjoining grains, giving rise to valley and ridges on the materials surface observed.

The total dislocation line energy depends on:

$$E_{TOT} = E_{core} + E_{elastic}$$

$E_{elastic} \sim G b^2/(1-v)$ where G is shear modulus

$E_{core}$ depends on DBs along dislocation line

Since $E_{core}$ is easily estimated from the cohesive energy, the choice of the preferred dislocation line direction will be determined by the spatial anisotropy in G. Knowing G allows prediction which growth orientations are stable and which will be prone to grain rotation, roughening and scattering.

This rotation of the dislocation lines changes the grain boundary and surface structure and impacts properties that depend on these structures, for example electrical, mechanical and thermal.

By controlling the interaction with the substrate or adding dopant atoms to the Grain boundaries makes it possible to modulate the forces that drive the rotation of the dislocation lines and hence control properties of the material surface.

Experimental Results

Nano-crystalline (NC) films contain grains with a preferred orientation, for example, face-centered-cubic (fcc) metal such as gold and copper (Cu) often grow with (111) surface orientations, so it might be expected that individual grains and Grain Boundaries (GBs) would coalesce to form films with smooth surfaces. However, low angle GBs (LAGBs) in metals, such as Cu, contain dissociated dislocations separated by stacking faults. The energies of the faults depend on the fault normal, which can induce grain rotation and concomitant surface roughening.

NC Cu films were investigated from the multigrain scale ~1 µm to the atomic scale using scanning tunneling microscopy (STM). A STM was used to map the local three-dimensional topography of GB intersections at surfaces with picometer precision. STM is insensitive to the degree of tilt axis misalignment from high symmetry directions that typically hampers transmission electron microscopy (TEM) analysis of GB structure. Shifts in the GB tilt axis away from that of the original LAGB in NC Cu films. This shift in tilt accompanied by GB energy minimization, effected by a change in the dislocation-line direction results in the introduction of ridges and valleys into the film. The present invention can control the tilt angle to control the size of the ridges and/or valleys of the metal film surface depending on the application required. Suitably the shear modulus properties are controlled as a mechanism to control the angle of tilt.

NC Cu films (thicknesses of 20 or 50 nm) were prepared by physical vapor deposition on top of a 7-nm-thick tantalum layer that had been coated on a silicon wafer (all depositions with the substrate at room temperature), as shown in Figure 3. These samples were etched with glacial acetic acid and loaded into an ultrahigh vacuum system equipped with a low-temperature STM. After gentle sputtering and annealing at ~300°C the surface was atomically clean with a root-mean-square (rms) roughness 0.5 nm over a 1- µm scale. The grain diameter was comparable to the film thickness. The grain surfaces were all (111) oriented, as confirmed by both atomic resolution STM images and *ex-situ* electron Kikuchi diffraction.

A perspective view of the topography of the Cu NC thin film is illustrated in Figure 4A. Figure 4A shows that in addition to the expected perfect 0.21 nm high surface steps (red arrow), the surface displays ridges and valleys, highlighted by the green and white arrows respectively, where GBs emerge at the surface. For the valley location shown in Figure 4a there was a 2.4° misalignment between the [111] normal of the two adjoining grains; the (111) surfaces of these grains were atomically flat.

The valley GB in Figure 5A comprised a sequence of dislocations. The Burgers circuit outlined in green encloses the entire distorted region associated with one of these dislocations. The closure failure of the Burgers circuit is the distance between two nearest-neighbor atoms in the (111) plane, which is $a/\sqrt{2}$, where a is the lattice constant; $a/\sqrt{2}$ is also the magnitude of the Burgers vector of a perfect lattice dislocation in Cu. It is possible to use the measured step heights associated with these dislocations to deduce their Burgers vectors.

Copper has a relatively small stacking fault (SF) energy of ~41 mJ/m$^2$; thus, lattice dislocations normally dissociate into $\alpha/6 \langle 112 \rangle$ Shockley partials separated by SFs. The sum of the step heights of each pair of Shockley partials, taking into account their senses, is equal to the step height of the lattice dislocation from which they were formed. A Burgers vector of $a/2[1\bar{1}0]$ dissociates into $a/6 [2\bar{1}1] + a/6 [1\bar{2}\bar{1}]$ Shockley partials. The first Shockley partial produced a step up on the (111) surface of height $a/6 [2\bar{1}1] \cdot [111]/\sqrt{3} = a/3\sqrt{3} = 70$ pm, which is one third of the (111) interplanar spacing. This observation is consistent with the measured step-profile in Figure 5B and earlier measurements. The second Shockley partial produced an equal and opposite step down (see inset of Figure 5B, where two partials are explicitly shown). The two partials had finite core widths; hence the $\pm 70$ pm step profile were spread out rather than abrupt.

It was found that GBs at valley and ridge locations had different corrugation amplitudes, see Figures 4B and 4C. The corrugation along the valley GB was between 60 pm and 80 pm, consistent with a series of Shockley partial pairs, whereas along the ridge it was smaller ~ 30 pm (Figure 4D). Figure 5C shows a GB with atomic resolution at a ridge. Burgers circuits revealed undissociated dislocations, and the location of each edge dislocation core was precisely determined. This result differed from the dissociated lattice dislocations in the GBs observed in valleys and was consistent with the breakdown of inversion symmetry due to the presence of LAGBs within the Cu(111) film.

To explain how grain tilting gives rise to the ridge and valley features seen in STM, consider the in-plane misorientation and assume that the dislocation lines are parallel to the surface normal [111]. The GB in Figure 5A displayed a periodic sequence of edge dislocations. The solid lines and dotted lines run along the $[\overline{1}12]$ and $[1\overline{1}0]$ directions in the adjoining grains, respectively. The repeat vectors $\overline{p}$ in the boundary plane of the two adjoining crystals are $(4 + 4 + 3)a/4[\overline{1}\overline{1}2] + 3a/4[1\overline{1}0] = a/2[\overline{4}\,\overline{7}\,11]$ and $a/2\,[\overline{7}\,\overline{4}\,11]$, each of length $p = a\sqrt{186}/2$ (see Figure 5A). The Burgers vector content $B = 3a/\sqrt{2}$ in each period $\overrightarrow{p}$ is related to the boundary misorientation 6 by Frank's formula, $\sin(\theta/2) = B/(2p)$. The estimated value $\theta = 17.9°$ was near the measured angle $16.2°$ in Figure 5A. Thus, the GB in Figure 5A was a symmetric tilt GB, the plane of which lies along the mean of the (110) planes of the adjoining grains.

However, it is unlikely the dislocation lines are parallel to the surface normal [111] because the plane of the SF ribbons plane between the partials would be $(11\overline{2})$ (on average) with narrow spacings and relatively large elastic repulsion between the partials. The low energy SFs in Cu are on {111} planes, not {112} planes. If the dislocation lines were parallel to [112], which is $19.47°$ from the [111] surface normal, the SFs would be on low-energy $(11\overline{1})$ planes. To minimize the SF energy and the overall GB energy, it is likely that the direction of the dislocation lines, and hence that of the composite rotation axis of the GB, lies somewhere between [111] and [112], which is consistent with the simulations below.

To effect this change, a second rotation is introduced so that the GB rotation comprises a rotation $\rho_1 = 1/\sqrt{3}\,[111]\tan(\theta/2)$ followed by a rotation $\rho_2 = \hat{g}\tan(\varphi/2)$, such that the composite rotation

$$\rho = \rho_2 * \rho_1 \stackrel{\text{def}}{=} \frac{\rho_1 + \rho_2 - \rho_1 \times \rho_2}{1 - \rho_1 \cdot \rho_2} \qquad (1)$$

is perpendicular to $[1\overline{1}0]$. It follows then from Eq. (1) that $\hat{g} = \cos(\theta/2)(1/\sqrt{6})\,[\overline{1}\overline{1}2] + \sin(\theta/2)(1/\sqrt{2})\,[1\overline{1}0]$ and the Rodrigues vector of the composite rotation is:

$$\rho = \tan(\theta/2)\left(\frac{\tan(\varphi/2)}{\sin(\theta/2)}\frac{1}{\sqrt{6}}\,[\overline{1}12] + \frac{1}{\sqrt{3}}\,[111]\right) \qquad (2)$$

which ensured that each dislocation has no net step height at the surface. The angle $\psi$ between [111] and the composite rotation axis, which is also the inclination angle between [111] and the dislocation lines, follows directly from Eq. (2): $\tan \psi = \tan(\theta/2)/\sin(\theta/2)$. For small $\theta$, this reduces to $\varphi \approx \theta \tan(\psi)$.

Figure 6 illustrates the relation between in-plane $\theta$ and out-of-plane $\varphi$ rotations and calculated GB energy. $\rho_2$ is a rotation about an axis lying in the boundary plane which tilts the (111) surfaces on either side of the GB through the angle $\varphi$ creating a valley or ridge. During the $\rho_2$ rotation, the GB boundary plane remains along the mean of the $(1\overline{1}0)$ planes and bisects the (111) planes of the adjoining grains (see Figure 6A). The rotation $\rho_2$ inclines the direction of the dislocation lines towards[112]. In the limit where $\tan \psi = 1/(2\sqrt{2})$ (i.e. $\psi = 19.47°$), the dislocation lines are entirely parallel to [112].

The distribution of experimentally measured values of $\theta$ and $\varphi$ are shown in Fig. 6B. Each open (closed) circle represents a GB at a valley (ridge); there is no obvious difference between the data at ridge and valley locations. The red line in Fig. 6B is a plot of $\tan \psi = \tan(\varphi/2)/\sin(\theta/2)$ with $\psi = 19.47°$, which sets the upper limit of the out-of-plane grain

rotation $\varphi$ for a given in-plane rotation 6. The black line with slope 0.25 is a linear fit to the data for valley GBs. These results mean that, on average, the dislocation line was inclined 14.04° from [111] direction instead of 19.47°. It can be attributed the 5° difference to the Cu-Ta interface, which limits the tilting of the Cu (111) planes.

The energies of GBs in free-standing (111) films can be calculated using molecular statics with periodic boundary conditions and an embedded atom method interatomic potential. Each repeat cell contained two GBs with equal and opposite misorientations. The GB structures were relaxed into their lowest energy states for combinations of prescribed in-plane and out-of-plane rotation angle, $\theta$ and $\varphi$, respectively. When a GB created a valley at the top surface of the film, it produced a ridge at the bottom surface, and vice versa (see Figure 6A). The GB energy as a function of the inclination angle $\psi$ is shown in Figure 6C. Regardless of the in-plane angle $\theta$, the GB energy was minimized at $\psi = 19.47°$. This result identified the out-of-plane rotation $\varphi$ with a reduction in the GB energy by aligning the dislocation lines along [112], which enabled SFs between the partial dislocations to be entirely on low energy $(11\bar{1})$ planes, yielding larger partial dislocation spacings and lower elastic energy. The reduction of LAGB energy is therefore due to the direction-dependent anisotropy of the dislocation-line energy. In the case of Cu, this anisotropy is predominantly due to the anisotropy of the SF energy.

Simulations confirm the film-tilting analysis at the atomic scale. The atomic structures of GBs with an in-plane rotation $\theta = 3.89°$ and three out-of-plane angles $\varphi$ are shown in Figure 7 from different viewing directions. When $\varphi = 0$ (Figure 7A), the SF ribbon is in the $(11\bar{2})$ plane on average and is composed of narrow facets of high energy (001) faults between $(11\bar{1})$ facets. As $\varphi$ increases, an increased inclination angle is found and wider SF ribbons with fewer jogs along their lengths and wider dislocation terminals at the surface (Figure 7B). When $\varphi = 1.37°$ (Figure 7C), corresponding to $\psi = 19.47°$, there are no jogs along the SF ribbon and the partial dislocation separation is maximized. Figure 7, B and C, also show that the SF ribbon is wider where the GB forms a valley (top surface), than where it forms a ridge (bottom surface). This trend is consistent with the experimental observation shown in Figure 5C, although in the experiment the partial dislocation separation appeared to reduce further than in the simulations (to near zero). This asymmetry is likely related to the edge and screw components of the two partials. At the intersection between the partial dislocations and the free surface, the two partial dislocations tends to rotate in the directions that increases their screw components. Since the sense of the rotation of each partial is the same at the two opposite free surfaces, at one surface the two partials will rotate such that they move away from each other while at the other surface the two partials will rotate such that they get closer together, consistent with the dissociation observed at valley and ridge sites.

It will be appreciated that the occurrence of ridges and valleys at emerging low-angle tilt boundaries reported here can be generalized to Cu films with different surface orientations. Elimination of jogs and high energy fault planes between dissociated dislocations requires both the dislocation line direction and Burgers vector to be in the same {111} plane. Therefore, only {112} films are expected to be immune to tilting since in this case the dislocation lines already lie in a {111} plane. The embodiments set forth here can also be extended to films of other fcc materials, like Ag, Au, and Ni. More generally, however, grain rotation is expected in any material that has a highly anisotropic dislocation-line energy.

It will be appreciated that grain rotation and surface tilting is expected to influence the properties of metals that are scale dependent and strongly influenced by interface and GB structure. The resistivity of Cu and other metal wires increases precipitously as the diameter is decreased, due primarily to increased surface scattering. When the grain size is below the mean free path (50 nm in Cu), the intrinsic anisotropy of the metal's Fermi surface in combination with grain tilting along the wire length, is expected to enhance the levels of surface scattering. Tilting can be modulated by doping the GBs or controlling the film-substrate interaction, providing potential routes to manipulate the properties of NC metal films.

In one embodiment polycrystalline Cu with surface normal (111) of small angle variation using scanning tunneling microscopy is shown. In regards to the out-of-plane misorientation, there are both valley grain boundaries and ridge grain boundaries. The core area structure of the valley grain boundary is consistent with the structure unit / grain boundary dislocation model, neglecting the out-of-plane misorientation. Images of the atomic structure also demonstrate that the valley grain boundary dissociates, whereas no dissociation is found at ridge grain boundary. It will be appreciated that surface effects (surface stress and image force) can have some impact on grain boundary dissociation at surface.

It will be further appreciated that in the context of the invention Copper is shown in the examples, however equally well the invention can be applies to other nano-scale metal materials. In addition the invention can be applied to non-metal materials.

In the specification the terms "comprise, comprises, comprised and comprising" or any variation thereof and the terms include, includes, included and including" or any variation thereof are considered to be totally interchangeable and they should all be afforded the widest possible interpretation and vice versa.

The invention is not limited to the embodiments hereinbefore described but may be varied in both construction and detail.

**Claims**

1. A nano-scale metal material comprising a polycrystalline or nano-crystalline grain structure wherein the orientation of at least one dislocation line within a grain boundary is modified to control the grain boundary structure and to control the size of a ridge or a valley on the metal material surface.

2. The nano-scale metal material of claim 1 wherein the value of the shear modulus anisotropy property of the metal material is selected to modulate a rotation of the at least one dislocation line.

3. The nano-scale metal material as claimed in any preceding claim wherein the dislocation line is configured to be modulated by doping at least one grain boundary.

4. The nano-scale metal material as claimed in any preceding claim wherein the grain boundary is modified to interface with another material or substrate.

5. The nano-scale metal material as claimed in any preceding claim wherein an in-plane tilt angle of the grain boundary is dependent on an out-of-plane rotation of at least one grain boundary.

6. The nano-scale metal material as claimed in any preceding claim wherein the grain boundary is configured to form a particular asymmetric structure.

7. The nano-scale metal material as claimed in any preceding claim wherein the grain structure is configured with a (112) or (110) plane structure.

8. A nano-scale metal material as claimed in any preceding claim wherein the metal is selected from a group comprising copper, nickel, gold or silver.

9. A nano-scale metal material as claimed in any preceding claim wherein the other material comprises a CMOS or electronic device interface.

10. A process for making a nano-scale metal material comprising a polycrystalline or nano-crystalline grain structure, said process comprising the step of modifying the orientation of at least one dislocation line within a grain boundary to control the grain boundary structure and to control the size of a ridge or a valley on the metal material surface.

Figure 1

Figure 2

Figure 3

Figure 4A

Figure 4B

**Figure 4C**

**Figure 4D**

Figure 5A

Figure 5B

Figure 5C

**Figure 6A**

**Figure 6B**

**Figure 6C**

Figure 7a

Figure 7b

Figure 7c

Europäisches
Patentamt

European
Patent Office

Office européen
des brevets

**PARTIAL EUROPEAN SEARCH REPORT**

Application Number

under Rule 62a and/or 63 of the European Patent Convention.
This report shall be considered, for the purposes of
subsequent proceedings, as the European search report

EP 17 18 0342

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 5 882 399 A (NGAN KENNY KING-TAI [US] ET AL) 16 March 1999 (1999-03-16) * claims 16-25; example 3 * ----- | 1-10 | INV. C23C14/02 C23C14/16 |
| X | DONOHUE H ET AL: "Low resistivity @a-tantalum in Cu/CVD low-k (Orion@?) integration", MICROELECTRONIC ENGINEER, ELSEVIER PUBLISHERS BV., AMSTERDAM, NL, vol. 64, no. 1-4, 1 October 2002 (2002-10-01), pages 299-305, XP004381198, ISSN: 0167-9317, DOI: 10.1016/S0167-9317(02)00802-X * paragraph [02.1] * ----- -/-- | 1-10 | |

TECHNICAL FIELDS
SEARCHED (IPC)

C23C

## INCOMPLETE SEARCH

The Search Division considers that the present application, or one or more of its claims, does/do not comply with the EPC so that only a partial search (R.62a, 63) has been carried out.

Claims searched completely :

Claims searched incompletely :

Claims not searched :

Reason for the limitation of the search:

see sheet C

| Place of search | Date of completion of the search | Examiner |
|---|---|---|
| The Hague | 21 February 2018 | Lavéant, Pierre |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04E07)

Europäisches
Patentamt

European
Patent Office

Office européen
des brevets

**PARTIAL EUROPEAN SEARCH REPORT**

Application Number

EP 17 18 0342

| | DOCUMENTS CONSIDERED TO BE RELEVANT | | CLASSIFICATION OF THE APPLICATION (IPC) |
|---|---|---|---|
| Category | Citation of document with indication, where appropriate, of relevant passages | Relevant to claim | |
| X | BRUNOLDI G ET AL: "Impact of narrow trench geometries on copper film crystallography", MICROELECTRONIC ENGINEERING, ELSEVIER PUBLISHERS BV., AMSTERDAM, NL, vol. 83, no. 11-12, 1 November 2006 (2006-11-01), pages 2208-2212, XP024954767, ISSN: 0167-9317, DOI: 10.1016/J.MEE.2006.10.005 [retrieved on 2006-11-01] * paragraph [0002] * ----- | 1-10 | |

**TECHNICAL FIELDS SEARCHED (IPC)**

Europäisches
Patentamt
European
Patent Office
Office européen
des brevets

**INCOMPLETE SEARCH**
**SHEET C**

Application Number

EP 17 18 0342

Claim(s) searched incompletely:
1-10

Reason for the limitation of the search:

The present claims 1-10 contain so many unclear terms or formulations that they relate to an extremely large number of possible products and methods.
The terms " nano-scale metal material" used in claims 1 and 10 is vague and unclear. It is known that every metal can get a polycrystalline structure with grains presenting a diameter in the nanometer range. Furthermore, every metallic nanostructure such as nanoparticles, nanowires etc... would fall under this denomination.
The wording "polycrystalline or nano-crystalline grain structure", used in claim 1, is unclear since, referring to a nano-scale material, the "polycrystalline structure" is composed of nano-crystalline grains and a "nano-crystalline grain structure" is a definition of polycrystallinity.
The term "a dislocation line within a grain boundary", used in claim 1, is unclear, since dislocations are not present in grain boundaries
The term "orientation of a dislocation (...) is modified", used in claim 1, is unclear since the modification or its previous status is unknown. Furthermore, it seems rather difficult to assess a material of undefined volume containing millions of dislocations based on a particular one.
The terms "is modified", "is selected to", "is configured to", used in claims 1-4, 6-7, is unclear and tries to define a product with an unclear process step so that no physical properties can be deducted from this wording
The term "an in-plane tilt angle of the grain boundary is dependent on an out-of-plane rotation of at least one grain boundary", used in claim 5, seems to have no clear meaning in physics.
The term "particular asymmetric structure", used in claim 6, is unclear
The term "grain structure configured with a (112) or (110) plane structure", used in claim 7, is unclear since every grain presents a (112) or (110) plane.
The term "comprising" used in claim 8 is not limiting and therefore, the metallic material disclosed is not characterised.
Claim 9 seems to indicate that a CMOS or an electronic device interface is a material, although a CMOS is a device comprising a plurality of devices and an interface cannot be seen as a material.
Claim 10 attempts to define the subject-matter in terms of the result to be achieved. Such a definition is only allowable under the conditions elaborated in the Guidelines F-IV, 4.10. In this instance, however, such a formulation is not allowable because it appears possible to define the subject-matter in more concrete terms, viz. in terms of how the effect is to be achieved.
Claims 1 and 10 are not supported by the description as required by Article 84 EPC, as their scope is broader than justified by the description and drawings. There is no basis in the description for any possible metallic material but only for copper and gold layers.
Therefore the definition of the subject-matter of said claims is extremely unclear (Article 84 EPC).
Non-compliance with the substantive provisions is such that a meaningful search of the whole claimed subject-matter of the claim can not be carried out (Rule 63 EPC and Guidelines B-VIII, 3) but only on what seems

Europäisches
Patentamt

European
Patent Office

Office européen
des brevets

**INCOMPLETE SEARCH
SHEET C**

Application Number

EP 17 18 0342

to be the invention according to the description, namely: the deposition of a nanocrystalline (111) Cu or (111) Au layer by PVD on a Ta-sublayer at room temperature followed by an etching with glacial acetic acid and an annealing at 300°C (Page 10-11, "experimental results").Even in looking at the disclosed experimental results, it seems that some essential features are missing, such as the time of the annealing so that the application might not be sufficiently disclosed contrary to the requirements of Art 83 EPC.

The search will be limited to a method as defined : deposition of a nanocrystalline (111) Cu or Au layer by PVD on a Ta-sublayer at room temperature followed by an etching with glacial acetic acid and an annealing at 300°C and to a product as defined: substrate comprising a nanocrystalline (111) Cu or (111) Au layer on a Ta-sublayer.

The applicant's attention is drawn to the fact that the application will be further prosecuted on the basis of subject-matter for which a search has been carried out and that the claims should be limited to that subject-matter at a later stage of the proceedings (Rule 63(3) EPC).

## ANNEX TO THE EUROPEAN SEARCH REPORT
## ON EUROPEAN PATENT APPLICATION NO.

EP 17 18 0342

This annex lists the patent family members relating to the patent documents cited in  the above-mentioned European search report.
The members are as contained in the European Patent Office EDP file on
The European Patent Office is in no way liable for these particulars which are merely given for the purpose of information.

21-02-2018

| Patent document cited in search report | | Publication date | Patent family member(s) | | Publication date |
|---|---|---|---|---|---|
| US 5882399 | A | 16-03-1999 | EP | 1010199 A1 | 21-06-2000 |
| | | | JP | 2001514446 A | 11-09-2001 |
| | | | KR | 20010022100 A | 15-03-2001 |
| | | | US | 5882399 A | 16-03-1999 |
| | | | WO | 9910921 A1 | 04-03-1999 |

EPO FORM P0459

For more details about this annex : see Official Journal of the European Patent Office, No. 12/82